# EUROPEAN PATENT SPECIFICATION

(11) **EP 0 404 101 B1**
(45) Date of publication and mention of the grant of the patent: **01.05.1996**
(21) Application number: 90111648.3
(22) Date of filing: 20.06.1990
(51) Int. Cl.: H01L 21/316

(54) **Method for depositing silicon dioxide film and product**
Methode und Anordnung zur Ablagerung einer Siliciumdioxydschicht
Méthode pour déposer un film de dioxyde de silicium et produit obtenu

(30) Priority: 22.06.1989 US 370331
(43) Date of publication of application: 27.12.1990
(73) Proprietor: WATKINS-JOHNSON COMPANY, Palo Alto California 94304 (US)
(72) Inventor: Mahawili, Imad, Los Gatos California 95032 (US)
(74) Representative: Blumbach, Kramer & Partner

(56) References cited:
- EP-A- 0 286 097
- WO-A-86/00753
- JOURNAL OF APPLIED PHYSICS, vol. 64, no. 8, 15th October 1988, pages 4168-4174,American Institute of Physics, Woodbury, NY, US; H. NONAKA et al.:"Photochemical vapor deposition of amorphous silica films using disilane andperfluorosilanes: defect structures and deposition mechanism"
- JOURNAL OF VACUUM SCIENCE & TECHNOLOGY B, vol. 1, no.1, January - March 1983, pages 54-61, American Vacuum Society, Woodbury, NewYork, US; R.M. LEVIN et al.: "The step coverage of undoped and phosphorus-dopedSiO2 glass films"

## Description

The present invention relates to a chemical vapor deposition method for depositing silicon dioxide as a hard, protective film and a product of the method, and more particularly to such a method and product where the silicon dioxide is deposited as a film on a selected substrate such as a silicon wafer.

### Background of the Invention

Chemical vapor deposition (CVD) has long been employed in the prior art for depositing films of material such as silicon dioxide on selected substrates. One of the most common applications for such deposition is formation of the silicon dioxide film as a dielectric layer in the fabrication of various solid state devices.

Typically, the silicon dioxide film is grown upon a substrate such as the silicon wafer by direct surface oxidation of the silicon at elevated temperatures. The present invention, however, is more closely related to processes where the silicon dioxide is deposited upon the substrate or silicon surface by chemical vapor deposition processes employing oxidation of a silicon containing compound in a vapor phase within a CVD reactor.

Such reactors and general processes are disclosed by a wide variety of references. Rather than attempting to cite representative references, general considerations or parameters are discussed briefly below for both the CVD reactors and deposition processes.

CVD deposition may be carried out in a variety of reactors which are commonly characterized as forming an enclosed chamber where the wafer or substrate is placed for contact with a vapor phase responsible for the deposition process. The reactors are typically equipped with means for controlling temperature and pressure within the chamber. In addition, the reactors may optionally include additional components such as an electrical discharge means for dissociating reactants in the vapor phase, for example, where plasma enhancement of the deposition technique is desired.

Within such a reactor, the process generally involves introduction of a reactant or deposition component for supplying silicon and an oxidant or oxidizing gas for supplying oxygen to form the silicon dioxide film.

Possibly the most common oxidation or deposition process employed in this regard includes silane gas as a reactant or source of silicon and oxygen gas as the oxidizing agent. This process is further carried out generally in a temperature range of about 300-500°C. and typically under relatively low pressure conditions, for example less than 5 Torr or 6,66 x 10 Pa.

Although it has been found possible to employ oxidation of silane gas to produce a silicon dioxide film of relatively high density and etch resistance, for example, this process has been found to suffer from serious limitations in conformality of the deposited film even on average device step geometry. In this regard, it is commonly desirable for devices contemplated by the invention to include substrate features on a micron scale. In any event, silane oxidation has been found to result in about 70% device step conformality of silicon dioxide film deposition for such average step geometry.

More recent developments have involved the use of decomposition and oxidation of more complex silicon bearing compounds to overcome this problem. More specifically, these processes involve decomposition and oxidation of mono-, di-, tri- and tetra- forms of silicates. One example of such a compound is tetraethylorthosilicate (TEOS) which is also representative of a broader class of materials which can be referred to as tetraalkoxyorthosilicates.

Numerous variations or equivalents are possible both for silicon bearing gases such as silanes (SiₙH₂ₙ₊₂) as well as silicate compounds such as TEOS. The silicon bearing compounds such as silane gases are generally characterized by the absence of oxygen directly bonded to the silicon in the compound. In addition to other silane gases as noted above, additional silicon bearing compounds include silicon tetrachloride and organosilicon compounds. The organosilicon compounds may include alkyl groups, cyclic groups or other organo components in mono-, di-, tri-- and tetra- forms in the silicon compound.

At the same time, other silicates have also been found useful including cyclic organosilicate compounds such as tetraethylcyclotetrasiloxane (commonly designated "TOMCATS").

Such silicate compounds are typically liquid under normal conditions and are vaporized in the CVD reactor. Deposition reactions for such compounds are commonly carried out at low pressures as noted above but at relatively elevated temperatures, typically in the range of 650-750°C.

Deposition of silicon dioxide films from silicate compounds as noted above has been found to substantially improve conformality of the deposited film over device steps to as high as 92%, typically in a range of 82-92%.

In order to lower the deposition temperature, other techniques have been employed in combination with both deposition of silicon from silicon compounds such as silane and from silicate compounds as listed above. For example, increased reactivity in the vapor phase has commonly been achieved through the introduction of ozone together with oxygen in the oxidant or oxidizing gas. Similar results have also been accomplished by the use of plasma enhancement as noted above. However, while providing improved conformality as noted above, such silicate compounds commonly cause deterioration in other film characteristics, particularly film density and hardness as indicated by standard etch rates.

In any event, the preceding discussion has been set forth to exemplify tradeoffs commonly encountered in prior art techniques, particularly in a variety of film characteristics for the silicon dioxide being deposited.

### Summary of the Invention

There has accordingly been found to remain a need for improved processing techniques and products of such processes for achieving enhanced combinations of film characteristics in silicon dioxide films deposited by CVD techniques. It is accordingly an object of the present invention to provide such an improved method and product.

The invention is defined by claims 1 and 11, respectively. The invention provides for enhanced film characteristics in the silicon dioxide film by introducing a combination of two different deposition or reaction compounds for interaction with the oxidant or oxidizing agent in the vapor phase of the CVD reactor. More specifically, the invention contemplates a first deposition compound or reactant which is termed a silicon source compound characterized by having its silicon free from direct bonding to oxygen. The other deposition or reaction compound is termed a silicate source compound and is characterized by having at least one oxygen directly bonded to its silicon nucleus.

With reference to the prior art discussion set forth above, a typical silicon source compound is a silane gas such as silicon tetrahydride and more broadly has the structure 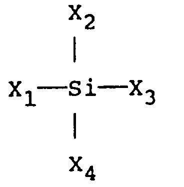 wherein X₁-X₄ are free from oxygen next to the silicon nucleus.

Similarly, the silicate source compound corresponds to the prior art silicate compounds discussed above and generally has the structure 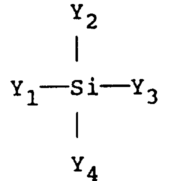 wherein at least one of the substituents Y₁-Y₄ includes an oxygen adjacent the silicon. In the above compounds, the X and Y substituents may otherwise be hydrogen or more complex radicals.

Preferably, the deposition compound contains from about 5 to about 95 parts by weight, more preferably from about 10 to about 90 parts by weight, each of a silicon source compound and a silicate source compound as defined above.

Within the ranges set forth above, the ratio of the silicon source compound to the silicate source compound is further selected, for example, in order to achieve a desired combination of film characteristics such as hardness or density and conformality in the silicon dioxide film.

It is a still further object of the invention to provide such a method and product wherein the combined deposition compound including both a silicon source compound and a silicate source compound is employed in a CVD reaction under a wide range of conditions such as temperature and pressure. For example, the CVD reaction of the present invention may be carried out under low pressure conditions, typically less than 6,66 x 10 Pa (5 Torr), and at higher pressure on the order of 1.01325.10⁵ Pa (1 atm) or, more specifically, at least 0,9299 Pa (0.9 atm). However, a typical high pressure reaction may be carried out at about 1.01325.10⁵ Pa (1 atm) according to the invention.

Similarly, the invention may also be carried out under a wide range of temperature conditions. Generally, the CVD reaction of the invention is carried out at a temperature of at least about 300°C. Thus, the reaction cf the present invention may be carried out in a temperature range of about 300-500°C. as noted above in connection with the use of silane as a single reactant. However, the CVD reaction of the present invention may also be carried out at higher temperatures including the range of 650-750°C. for silicates as discussed above and even at higher temperatures including 1,000°C. or more.

Still further, the CVD reaction of the present invention may also be carried out with enhancement of film deposition by one or more techniques. For example, ozone may be employed in combination with oxygen as the oxidant or oxidizing agent. Similarly, plasma enhancement may also be used within the CVD reactor for certain applications of the invention as desired.

To more specifically identify the two part deposition compound as outlined above, the silicon source compound is preferably selected from the class consisting of silanes, organosilicons, halide compounds such as silicon tetrachloride, etc. At the same time, the silicate source compound is preferably selected from the class consisting of mono-, di-, tri- and tetra-forms of alkoxysilicates and alkoxycyclicsilicates such as those identified above and others described in greater detail below. It is a still further object of the invention to provide a geometric silicon device as a product of a CVD reaction of the type outlined above wherein a silicon dioxide film is formed on the device substrate with reactants including both silicon and silicate source compounds adapted for interaction with an oxidizing agent in a vapor phase for deposit upon the substrate, the device comprising a silicon substrate and a silicon dioxide film exhibiting film characteristics of about 0.05-3 x 10⁸ Pa, preferably 0.05-0.5 x 10⁸ Pa tensile stress, about 1,000-2,000 Å/min, preferably 1,000-1,500 Å/min etch rate (with standard oxide etchant: 10 % hydrofluoric acid in water), about 80-95%, preferably 82-92% step coverage and the ability to accept dopaants. Other film characteristics may also be achieved to varying degrees according to the present invention and depending upon the particular application contemplated for the device. Furthermore, film characteristics of the silicon dioxide film on the device may be varied according to the present invention, particularly by varying the ratio of the silicon and silicate source compounds as noted above.

Additional objects and advantages of the invention are made apparent in the following description having reference to the accompanying drawings.

### Brief Description of the Drawings

FIGURE 1 is a partially schematic and partially diagrammatic representation of a nucleophilic decomposition mechanism proposed or contemplated for a silicate source compound alone, typically TEOS as discussed above.

FIGURE 2 is a similar representation illustrating conformal step coverage achieved on a geometric step device with TEOS alone while listing various disadvantages for that system. Accordingly, both FIGURES 1 and 2 relate to the prior art.

FIGURE 3 is also a similar representation of a hybrid kinetic dielectric deposition process according to the present invention illustrating conformal step coverage achieved on a geometric step device by the present invention and illustrating advantages achieved through the combined use of a silicon source compound and a silicate source compound in the deposition process.

### Description of the Preferred Embodiments

Referring generally to the drawings, a prior art deposition process involving only a silicon source compound such as silane is not illustrated. Rather, it is believed to be well known that silane can be employed to deposit silicon dioxide films with excellent characteristics such as film density and hardness. However, silane by itself has not been found suitable for developing high degrees of conformality.

For that reason, other prior art processes have been developed employing silicate source compounds such as TEOS and equivalent materials as described above for achieving generally excellent levels of conformality, in the range of about 82-92%, but suffering in related film characteristics such as film density and hardness as noted above, especially when deposited at 300-500°C.

The desire to use silicate source compounds has become particularly important with further advancement in the semiconductor device technology resulting in the shrinking of device line geometry down to the range of one micron and even lower.

For this reason, deposition techniques including silicate source compounds have developed with the further use of techniques such as plasma enhancement and inclusion of ozone in the oxidizing agent in an attempt to beneficially effect deposition of the silicon dioxide film from silicate source compounds such as TEOS. These reactions with plasma enhancement and ozone took place at relatively reduced temperatures, typically about 400°C.

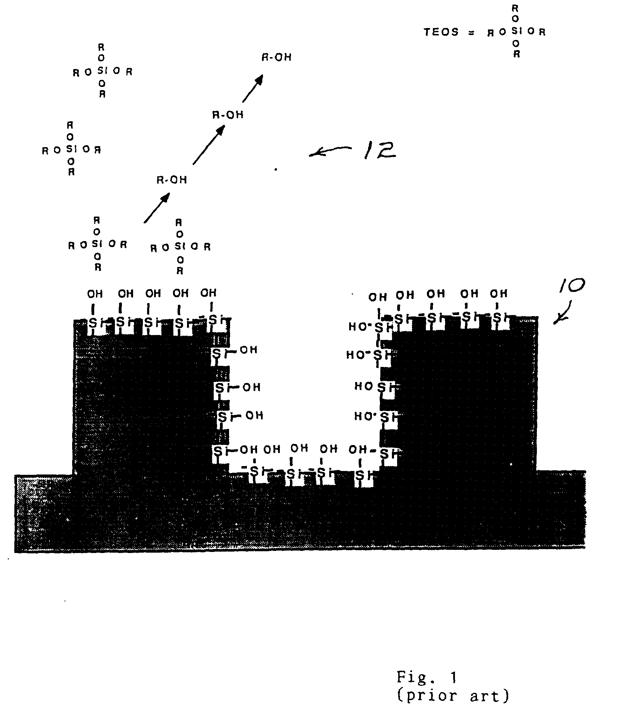

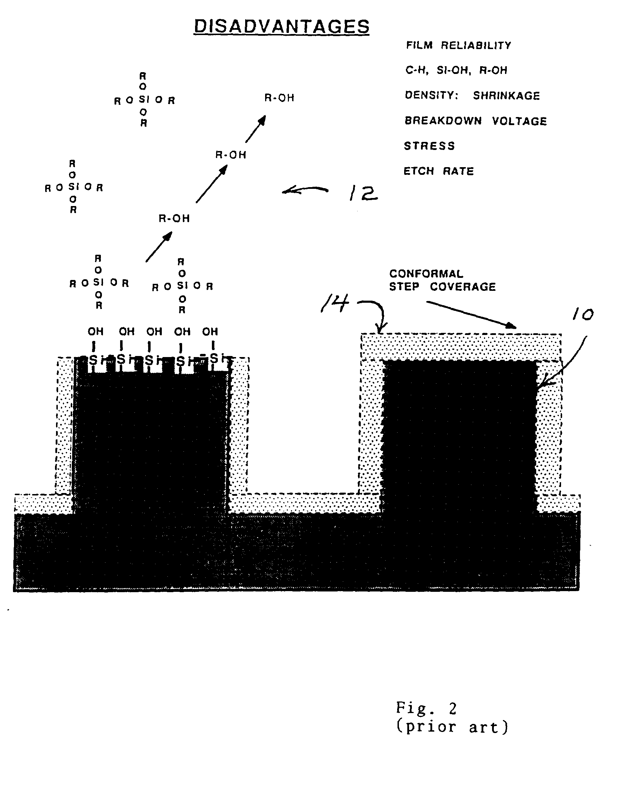

FIGURES 1 and 2 illustrate a broad range of prior art techniques for deposition from a silicate source compound alone. Referring to FIGURE 1, the silicate substrate 10 is illustrated in a form typical from hydration by water in the surrounding atmosphere. FIGURE 1 further illustrates a prior art silicate source compound by itself in a vapor phase 12 generally adjacent the substrate 10. It is of course understood that the substrate 10 and vapor phase 12 are formed or arranged within a suitable CVD reactor of the type described above in order to maintain controlled atmospheric conditions.

Actual deposition from the single silicate source compound is further represented in FIGURE 2 with generally good conformal step coverage being achieved as being generally indicated at 14. However, FIGURE 2 also illustrates relative disadvantages for the prior art techniques involving a single silicate source compound such as TEOS. Those disadvantages are graphically listed in FIGURE 2 and include disadvantages such as film reliability or, more specifically film unreliability, due for example to inclusion of undesirable radicals such as -CH, -SiOH, -ROH, etc. Furthermore, as noted above, such prior art techniques have also suffered from undesirable film density resulting, for example in shrinkage which prevents proper electrical functioning of the device.

Other film characteristics which suffer in such prior art deposition techniques involve electrical characteristics such as breakdown voltage and dielectric constant and, more specifically, film stress and etch rate which are discussed in greater detail below with reference to the present invention.

With this background discussion based on the prior art, the present invention provides a deposition or CVD process and product of that process wherein greatly enhanced silicon dioxide film characteristics are achieved through the combination of a silicon source compound and a silicate source compound in the vapor phase of the process. In summary, prior to a more detailed description, the present invention therefore provides a novel chemical process whereby a silicate source compound such as TEOS is oxidized at a relatively low temperature, for example 400°C., in the presence of a silicon source compound such as silane, or more specifically silicon tetrahydride. In this summary statement, TEOS and silane are considered representative of a broad range of silicate source compounds and silicon source compounds as defined in greater detail above.

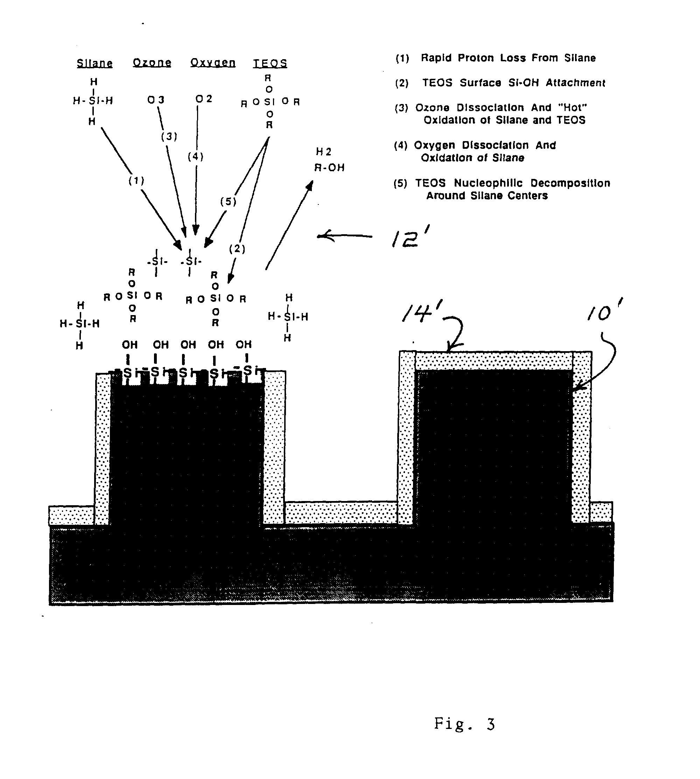

This reaction is illustrated in FIGURE 3 which provides a graphic representation of the hybrid kinetic schemes, generally indicated at (1), (2), (3), (4), (5). These kinetic schemes are also identified in tabular form in FIGURE 3 in an attempt to possibly explain advantages achieved by the present invention in combined deposition from a silicon source compound and a silicate source compound. Generally, the present invention is not intended to be limited by specific theory or discussion, as set forth hereinbelow with reference to FIGURE 3. Rather, this theoretical discussion is provided only in the form of hypothesis and for the purpose of possibly enabling a more complete understanding of the invention.

In any event, it is theorized that the presence of the relatively highly reactive silane in FIGURE 3 during the kinetic process of the invention provides attachment sites for facilitating reaction of the TEOS.

With such a combination, the ratio of silane to TEOS in the vapor phase may be varied to further adjust film quality and step coverage of the film on the semiconductor device structure or substrate 10′. Optimal film quality with low etch rates and high density and tailored stress with optimal step coverage conformality may thus be achieved by adjusting the silane to TEOS ratio and the ratio of the oxidizing agent to the deposition combination of the silicon/silicate source compounds.

The present invention, as briefly summarized immediately above, is described in greater detail below followed by a discussion of Table A. Table A provides a further comparison of the present invention with the prior art while also providing a range for examples possible within the scope of the present invention.

Initially, the invention contemplates a combined deposition or reaction component with both a silicon source compound and a silicate source compound as defined for the purposes of the present invention. Generally, silanes characterized by the formula SiₙH₂ₙ₊₂ and more specifically silane or silicon tetrahydride is the preferred silicon source compound.

In that regard, silane or silicon tetrahydride is an excellent source for dielectric or silicon dioxide film formation, at least in terms of selective film characteristics as discussed above. Another silicon source compound in terms of the present invention are organosilicon compounds which may be mono-, di-, tri- or tetra- forms of silicon compounds with the radicals being various organic substituents. In that regard, the organosilicon compounds forming silicon source compounds for the invention are generally similar to the TEOS and TOMCATS compounds and the general compounds corresponding thereto except for the absence of oxygen bonded to the silicon nucleus. In other words, it is important to note that the organosilicons forming silicon source compounds for the present invention do not include oxygen, at least bonded directly to the silicon nucleus.

Thus, as noted above, the silicon source compound may be characterized by the structure 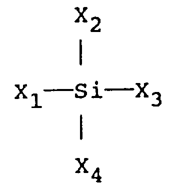 where X₁-X₄ are free from oxygen, at least bonded directly to the silicon nucleus, and may otherwise be any combination of -H, -Cl and/or alkyls, cyclic compounds and other organo forms. However, preferred in terms of the present invention are the organosilicons and more preferably silanes broadly and more specifically silane or silicon tetrahydride.

Also as was noted above, the silicate source compound, of which TEOS and TOMCATS are representative, preferably has the structure 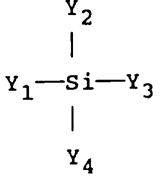 wherein at least one of the substituents Y₁-Y₄ includes an oxygen bonded to the silicon nucleus and organo compounds which may be linear, branched or cyclic in nature. Preferred in terms of the present invention are the TEOS and TOMCATS compounds noted above as well as their direct equivalents.

The silanes are gases whereas the silicate source compounds tend to be liquids which are accordingly vaporized prior to being introduced into the vapor phase 12. The TEOS compound and equivalent structures are disclosed for example by Priestley, et al. U.S. Patent 4,282,268 issued August 4, 1981. The TOMCATS compounds and equivalents were developed more recently but are also known in the art. Generally, the specific TOMCATS compound noted above is chemically identified as C₄H₁₆Si₄O₄.

The reactions contemplated by the present invention and discussed above with reference to FIGURE 3 are very complex. Accordingly, it is to be understood that the present description is not intended to provide a limiting description of those reactions in terms of the present invention but only to hypothesize the hybrid kinetic deposition technique made possible by the present invention. In an overall view, the silicon source compound (silane or equivalent) and the silicate source compound (TEOS or equivalent) plus heat and an oxidizing agent such as oxygen with or without ozone, occurring in a vapor phase, results in deposition of a silicon dioxide film plus radicals including -ROH, -SiOH and other products.

In carrying out the deposition reaction, it is necessary to provide elemental silicon (tetravalent silicon) and oxygen or ozone as an oxidant on or adjacent the substrate surface to permit formation of the desired SiO₂ film. During film formation, it is most important to remove all radical substituents from the silicon nucleus in order to prevent them from entering into and interfering with reaction of the silicon and oxygen to form the SiO₂ film.

Formation of the SiO₂ must necessarily take place at the substrate surface rather than in the vapor phase (as may undesirably occur in an "overloaded reactor"). Silicon dioxide particles forming in the vapor phase and then depositing on the substrate will tend to "kill" the device electrically.

Upon being heated near the vicinity of the wafer, silane (as well as the other silicon source compounds) very rapidly dissociates to form the elemental silicon necessary for film formation. Globally, the silane initially dissociates rapidly to-SiH₂, a silane radical having an even greater affinity for oxygen than silane and very rapidly oxidizing to form silicon dioxide on the substrate surface.

With the silicate source compounds such as TEOS or TOMCATS, dissociation of their radical groups to form elemental silicon suitable for oxidation to silicon dioxide occurs very slowly and, by itself, commonly results in poor film density and other film characteristics as noted above, unless the temperature exceeds the 600-700°C. range.

Within the present invention, formation of silicon dioxide by silane or the silicon source compound is believed to serve two functions of (1) enhancing deposition of silicon dioxide from the silicate source compound with improved film characteristics and (2) in itself, densifying the film and producing other desirable film characteristics.

It is further theorized that problems encountered with silicate source compounds such as TEOS alone arise in that good deposition sites are not sufficiently available on the substrate surface to promote SiO₂ deposition. The silicon source compound such as silanes and their equivalents are believed to overcome that problem by providing the necessary deposition sites throughout the growing film to enhance SiO₂ deposition from TEOS and the other silicate source compounds. Thus, the hybrid process of the invention accelerates the reaction of the silicate source compound with the oxidizing agent to improve film density and at the same time, changing kinetics of the process in a desirable manner.

It is again noted that the silicate source compound such as TEOS or its equivalent achieves the desired step coverage or conformality combination of the silicate source compound with the silicon source compound according to the present invention maintains that desirable step coverage or conformality while also achieving other desirable film characteristics such as film stress, film density, etc.

It is again noted that the general reaction kinetics for such reactions are not entirely understood even by those skilled in the art. Accordingly, the discussion herein of hybrid kinetics for the present invention is set forth mainly as hypothesis and only for the purpose of attempting to facilitate understanding of the invention without limiting it.

The oxidant or oxidizing agent may also be varied according to specific film characteristics required. Generally, the oxidizing agent includes oxygen either with or without ozone. Oxygen performs well as an oxidizing agent with a silicon source compound such as silane, even at low temperatures of about 400°C. However, oxygen reacts very slowly with silicate source compounds such as TEOS and the like at 300-400°C. That reaction may accordingly be accelerated by combining about 4-5% ozone in the oxygen to take advantage of the greater oxidizing power of the ozone.

The deposition compounds including both the silicon source compounds and silicate source compounds may be combined with a carrier gas which is preferably an inert gas such as nitrogen, argon or helium in order to introduce the reactant into the vapor phase along with the oxidizing agent. The deposition compounds including the silicon source compound and the silicate source compound may either be initially blended together and vaporized prior to introduction into the vapor phase. However, it is to be understood that a wide variety of techniques are possible in regard to production of various components into the CVD reactor.

The preceding discussion is intended to illustrate an almost infinite number of examples possible with the specific compounds identified above and other operating parameters including temperatures, pressures and particularly the ratio of silicon source compound to silicate source compound as well as the ratio of those compounds to the oxidizing agent.

The selection of those components and operating parameters is dependent upon desired film characteristics for the silicon dioxide. Certain of the film characteristics of particular concern were discussed above with reference to FIGURES 2 and 3. In that regard, "film reliability" is related to electrical performance of the substrate or device, for example, breakdown voltage, dielectric constant, etc. These desirable characteristics are reduced by the presence of undesirable compounds such as the -SiOH, -SiR, carbon, etc. in the deposited film. To over simplify, desired electrical characteristics such as breakdown voltage and dielectric constant are achieved with a pure silicon dioxide film, providing proper stability over time.

Higher film density and low film shrinkage ratios relate to the desirability for maintaining maximum density in the film as discussed above. The impurities discussed above tend to undesirably reduce film density.

Film stress and etch rate are particularly effective measures of film quality. Those characteristics are further defined below in connection with Table A. Generally, film stress is defined in units of dynes/cm = 10⁻¹ Pa, either in tension and/or compression. Film stress is preferably reduced to a level of about 5-7 x 10⁸ to about 1 x 10⁹. High levels of film stress will commonly result in film cracking and undesirable discontinuity. This may be pictured as the film being under undesirable stress, resulting in cracking, etc. It is of course desirable to deposit the silicon dioxide film to thicknesses of one, two or three microns or more without development of cracks.

As noted above, silane alone has been found to minimize film stress and prevent undesirable cracking. By contrast, silicate source compounds such as TEOS and its equivalents, particularly in the presence of ozone, are well known for producing films with cracks. Thus, it has been found that the advantageous combination of the silicon source compound and silicate source compound of the present invention is able to control film stress and eliminate cracking while at the same time achieving greatly enhanced step coverage as noted above.

The terms "conformality" and "step coverage" apply to film formation on different geometric surfaces of the substrate steps. This characteristic is particularly important where thin silicon dioxide films as low as one micron are being formed.

As noted above, a broad range of component ratios and operating parameters are contemplated by the present invention in order to cover a variety of possible end use applications where various values, particularly film characteristics are tailored to achieve specific purposes. For example, one application may tolerate as much as 1,500 Angstroms per minute in etch rate so that only a small amount of silane or silicon source compound need be used with a large amount of silicate source compound, for example, to achieve increased conformality, etc.

Yet another application may have a larger geometry and be able to tolerate lower step coverage; thus, a high ratio of silicon source compound to silicate source compound would be desirable in order to achieve increased density, etch rate, etc.

Various operating parameters and component selection in terms of the present invention is still further illustrated in Table A as set forth below. In addition, that table further distinguishes the hybrid kinetic deposition technique of the present invention from various techniques practiced in the art.

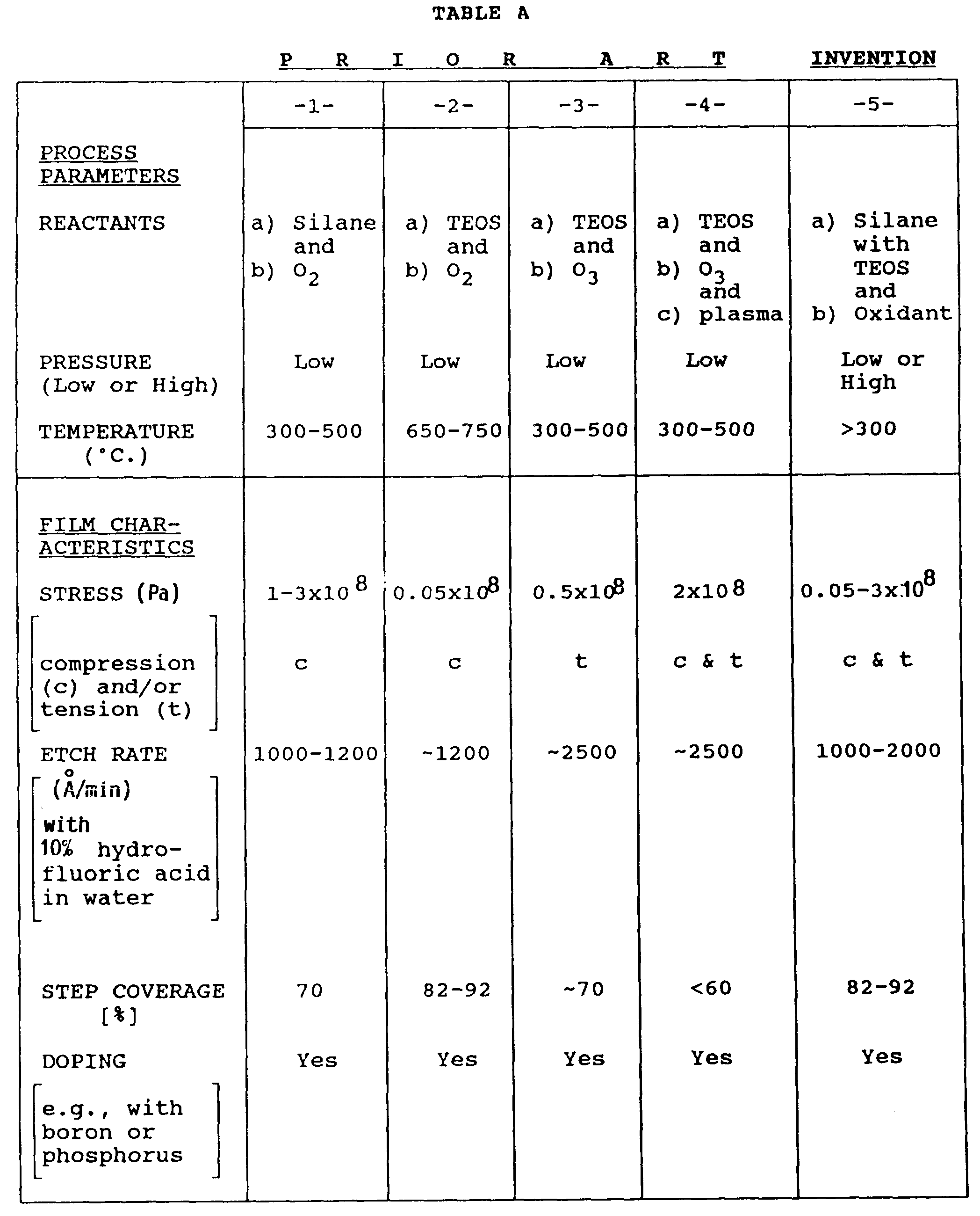

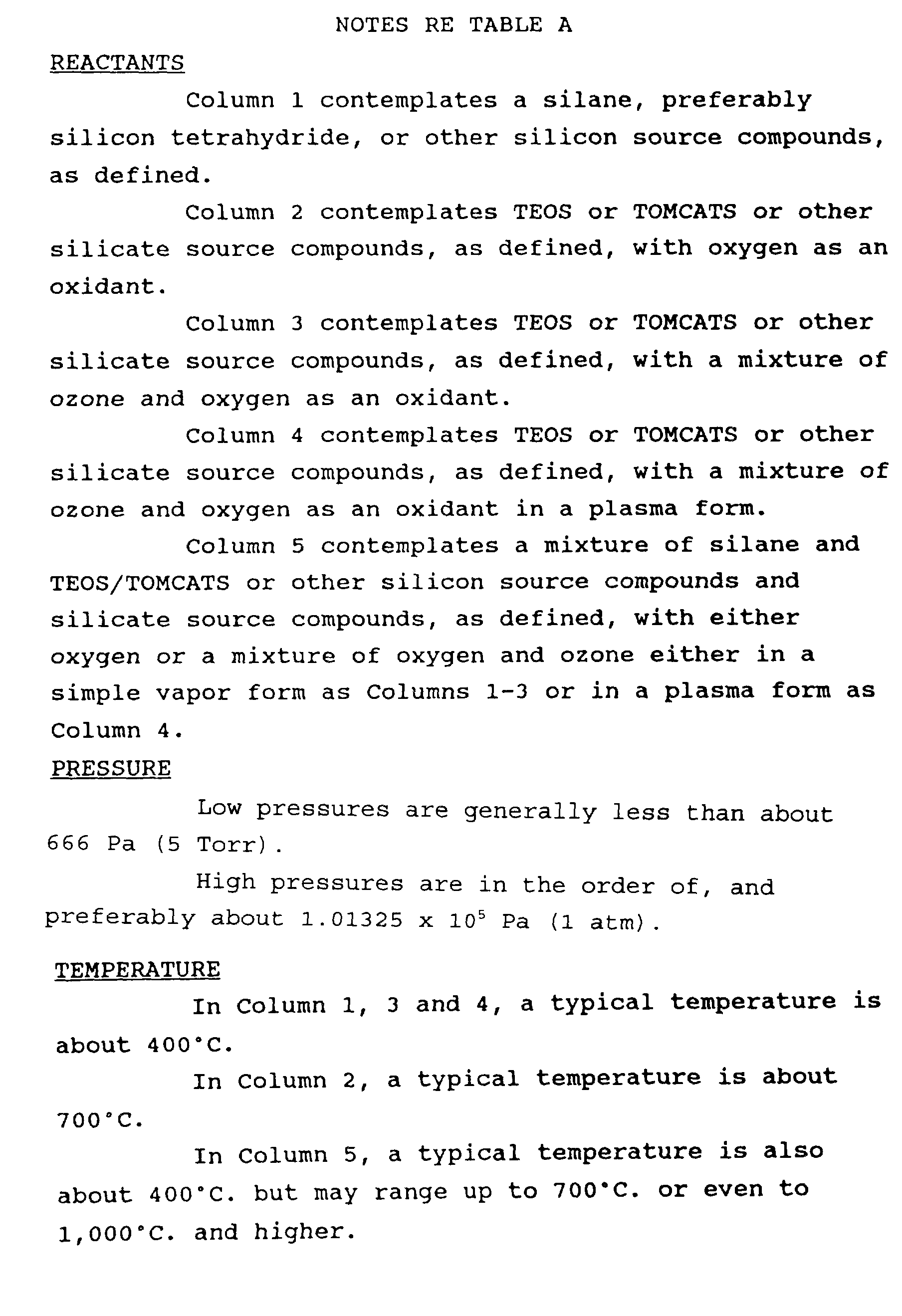

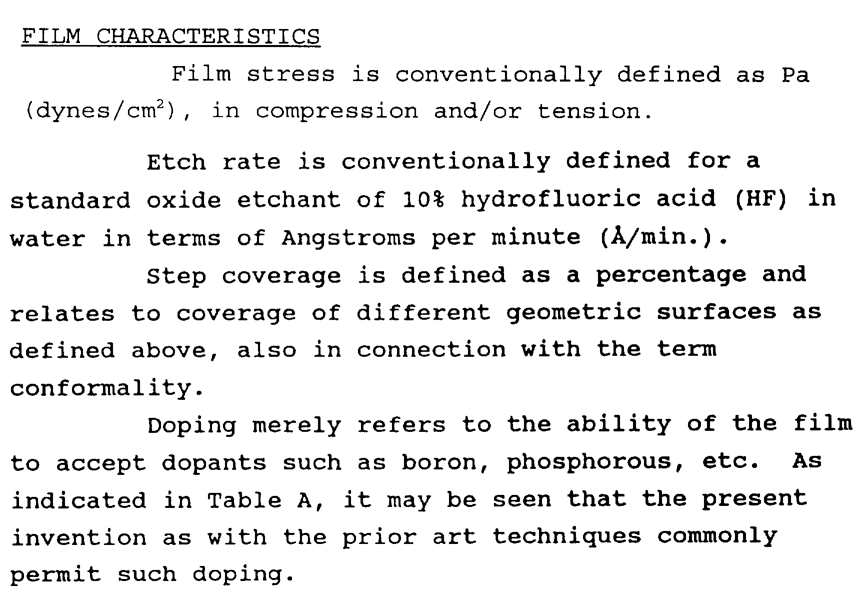

Thus, Table A sets forth process parameters and film characteristics for a variety of prior art techniques identified in Columns 1-4. The hybrid kinetic deposition process of the present invention is identified in Column 5 in terms of process parameters and film characteristics. It is again noted that a wide variety of desirable film characteristics can be achieved by varying the ratio of silicon source compound to silicate source compound as discussed above.

In any event, Table A and a comparison of Column 5 with prior art Columns 1-4, clearly indicates that the hybrid kinetic deposition process of the present invention is capable of at least equaling most desirable film characteristics common for silane deposition alone (see Column 1) while also achieving improved conformality or step coverage typical of a silicate source compound such as TEOS alone.

The film characteristics set forth in Table A are further indicative of a product produced by the method of the present invention. That product is preferably in the form of a substrate such as a silicon wafer with a silicon dioxide film formed thereon and having characteristics such as those set forth in Table A.

Thus, there has been provided a description of the various operating parameters and components for carrying out a novel hybrid kinetic deposition process and producing a product of that process with unique identified characteristics. Numerous modifications and variations of the invention in addition to those specifically noted above will also be apparent to those skilled in the art. Accordingly, the scope of the present invention is defined only the the following appended claims which are also set forth by way of further example to the invention.

## Claims

1. A CVD method for depositing silicon dixoide as a hard, protective film on a substrate having steps on its surface, especially for a solid state device, comprising the steps of
arranging the substrate in a close chamber of a CVD reactor, said reactor including means for controlling temperature and pressure within said chamber,
introducing a composite deposition compound and an oxidizing compound in a vapor phase into the chamber adjacent the substrate,
the composite deposition compound being selected to be of a combination of a first deposition compound and a second deposition compound, said first deposition compound being a silicon source compound having its silicon free from direct bonding to oxygen and being contained in said composite compound in approximately 5 to 95 parts by weight and said second deposition compound being a silicate source compound with at least one oxygen directly bonded to its silicon, and
thermally dissassociating the composite deposition compound and the oxidizing compound in the vapor phase and adjacent the substrate at a temperature exceeding approximately 300°C, to cause deposition and formation of the silicon dixoide film on said substrate.

2. The method of claim 1
wherein the ratio of the silicon source compound with respect to the silicate source compound is selected dependent upon step geometry of the substrate to achieve a tradeoff between desired hardness or density and conformality together with etch rate for the silicon dioxide film, the ratio being small to achieve increased conformality, and high to achieve increased density.

3. The method of claim 1 or 2 further comprising the step of maintaining pressure in the chamber at a controlled level up to as much as 1.01325 x 10⁵ Pa (1 atm).

4. The method of any of claims 1-3
wherein a low pressure condition of less than about 666 Pa (5 Torr) is maintained in the chamber.

5. The method of any of claims 1-4
wherein the silicon source compound has the structure 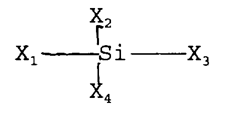 wherein X₁-X₄ are free of oxygen next to their silicons and the silicate source compound has the structure 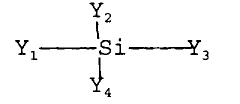 wherein at least one of the substituents Y₁-Y₄ includes an oxygen adjacent the silicon.

6. The method of claim 5
wherein the silicon source compound is selected from the class consisting of silanes, organosilicons, silicon halides and mixtures thereof.

7. The method of claim 5
wherein the silicate source is selected from the class consisting of mono-, di-, tri- and tetra-forms of alkoxy silicates and alkoxycyclic silicates, halide derivatives thereof and mixtures of the above.

8. The method of claim 5
wherein the silicate source is selected from the class consisting of mono-, di-, tri- and tetra-forms of alkoxy silicates and cyclic silicates, halide derivatives thereof and mixtures of the above.

9. The method of any of claims 1-4
wherein the silicon source compound is a silane and the silicate source compound is tetraalkyloxyorthosilicate or tetraalkoxycyclic silicate.

10. The method of any of claims 1-4
wherein the silicon source compound is silicon tetrahydride and the silicate source compound is tetraethoxyorthosilicate or tetraethylcycloxyorthosilicate.

11. A silicon device having a surface with steps on it, a silicon dioxide film formed thereon in a CVD reactor by using any of the methods set forth in claims 1-10, wherein said silicon dioxide film exhibits film characteristics of about 0.05-3 x 10⁸ Pa (0.05-3 x 10⁹ dynes/cm) stress, about 1000-2000 Å/min etch rate, when etched with standard 10% hydrofluoric acid in water, and about 80-95% step coverage.

12. The device of claim 11
wherein stress is about 0.05-0.5 x 10⁸ Pa.

13. The device of claim 11
wherein etch rate, when etched with the standard 10% hydrofluoric acid in water, is about 1000-1500 Å/min.

14. The device of claim 11
wherein step coverage is about 82-92%.

## Patentansprüche

1. CVD-Verfahren zum Niederschlagen von Siliciumdioxid als ein harter Schutzfilm auf einem Substrat mit Stufen auf seiner Oberfläche, insbesondere für eine Festkörpervorrichtung, mit folgenden Schritten:
das Substrat wird in einer geschlossenen Kammer eines CVD-Reaktors angeordnet, wobei der Reaktor Einrichtungen zur Steuerung der Temperatur und des Druckes innerhalb der Kammer aufweist;
eine zusammengesetzte Niederschlagsverbindung und eine oxidierende Verbindung in Dampfphase werden in die Kammer benachbart dem Substrat eingeführt;
die zusammengesetzte Niederschlagsverbindung wird als eine Kombination einer ersten Niederschlagsverbindung und einer zweiten Niederschlagsverbindung ausgewählt, wobei die erste Niederschlagsverbindung eine Quellenverbindung für Silicium mit Silicium-Atomen darstellt, die frei von direkter Bindung zu Sauerstoff sind und welche Verbindung in der zusammengesetzten Verbindung mit ungefähr 5 - 95 Gewichtsteilen enthalten ist, und wobei die zweite Niederschlagsverbindung eine Quellenverbindung für Silicat darstellt, bei dem mindestens ein Sauerstoff-Atom direkt mit dem Silicium verbunden ist, und
die zusammengesetzte Niederschlagsverbindung und die oxidierende Verbindung in der Dampfphase werden benachbart dem Substrat bei einer Temperatur oberhalb von ungefähr 300°C thermisch dissoziiert, um den Niederschlag und die Bildung des Siliciumdioxidfilms auf dem Substrat zu bewirken.

2. Verfahren nach Anspruch 1,
dadurch gekennzeichnet, daß das Verhältnis der Quellenverbindung für Silicium mit Bezug auf die Quellenverbindung für Silicat in Abhängigkeit von der Stufengeometrie des Substrats gewählt wird, um einen Kompromiß zwischen erwünschter Härte oder Dichte und Anpassung oder Konformität zusammen mit der Ätzrate für den Siliciumdioxidfilm zu erzielen, wobei das Verhältnis klein ist, um vergrößerte Konformalität zu erzielen, und hoch, um erhöhte Dichte zu erzielen.

3. Verfahren nach Anspruch 1 oder 2,
dadurch gekennzeichnet, daß der Druck in der Kammer auf einem gesteuerten Pegel bis zu 1,01325 x 10⁵ Pa (1 atm) aufrecht erhalten wird.

4. Verfahren nach einem der Ansprüche 1 bis 3,
dadurch gekennzeichnet, daß ein Niederdruckzustand von weniger als ungefähr 666 Pa ( 5 Torr) in der Kammer aufrecht erhalten wird.

5. Verfahren nach einem der Ansprüche 1 bis 4,
dadurch gekennzeichnet, daß die Siliciumquelle die Struktur 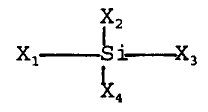 aufweist, wobei X₁ - X₄ benachbart zu ihren Siliciumatomen frei von Sauerstoff sind und die Silicatquelle folgende Struktur aufweist 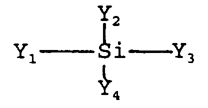 worin mindestens einer der Substituierenden Y₁ - Y₄ ein Sauerstoff-Atom benachbart dem Siliciumatom umfaßt.

6. Verfahren nach Anspruch 5,
dadurch gekennzeichnet, daß die Quellenverbindung für Silicium aus der Klasse bestehend aus den Silanen, Organosilicium-Verbindungen, Siliciumhaliden und Mischungen dieser Bestandteile ausgewählt sind.

7. Verfahren nach Anspruch 5,
dadurch gekennzeichnet, daß die Silicatquelle von der Klasse bestehend aus Mono-, Di-, Tri- und Tetra-Formen der Alkoxisilicaten und der alkocyclischen Silicaten, den Halidderivaten hiervon sowie von Mischungen dieser Bestandteile ausgewählt ist.

8. Verfahren nach Anspruch 5,
dadurch gekennzeichnet, daß die Silicatquelle von der Klasse bestehend aus Mono-, Di-, Tri- und Tetra-Formen von Alkoxisilicaten und cyclischen Silicaten, den Halidderivaten hiervon sowie von Mischungen dieser Bestandteile ausgewählt wird.

9. Verfahren nach einem der Ansprüche 1 bis 4,
dadurch gekennzeichnet, daß die Quellverbindung für Silicium eine Silan darstellt und die Quellverbindung für Silicat Tetraalkyloxiorthosilicat oder tetraalkoxicyclisches Silicat ist.

10. Verfahren nach einem der Ansprüche 1 bis 4,
dadurch gekennzeichnet, daß die Quellverbindung für Silicium Siliciumtetrahydrid und die Quellverbindung für Silicat Tetraethoxiorthosilicat oder Tetraethylcyclooxyorthosilicat ist.

11. Siliciumvorrichtung, deren Oberfläche mit Stufen versehen ist, auf denen ein Siliciumdioxidfilm in einem CVD-Reaktor durch Anwendung der Verfahren nach einem der Ansprüche 1 bis 10 gebildet worden ist,
dadurch gekennzeichnet, daß der Siliciumdioxidfilm Schichteigenschaften von ungefähr 0,05 bis 3 x 10⁸ Pa (0,05 bis
3 x 10⁹ Dyne/cm) mechanische Spannung, ungefähr 1000 bis 2000 Angström/Minute Ätzrate bei Ätzung mit standardisierter 10%iger Hydrofluorsäure in Wasser und ungefähr 80 bis 95 % Stufenabdeckung zeigt.

12. Vorrichtung nach Anspruch 11,
dadurch gekennzeichnet, daß die Spannung ungefähr 0,05 bis 0,5 x 10⁸ Pa beträgt.

13. Vorrichtung nach Anspruch 11,
dadurch gekennzeichnet, daß die Ätzrate, wenn die Ätzung mit der standardisierten 10%igen Hydrofluorsäure in Wasser erfolgt, ungefähr 1000 bis 1500 Angström/Minute beträgt.

14. Vorrichtung nach Anspruch 11,
dadurch gekennzeichnet, daß die Stufenabdeckung ungefähr 82 bis 92 % beträgt.

## Revendications

1. Procédé CVD (dépôt chimique en phase vapeur) pour déposer du dioxyde de silicium sous forme d'un film protecteur dur sur un substrat ayant des marches sur sa surface, en particulier pour un composant monolithique, comprenant les étapes de disposition du substrat dans une enceinte fermée d'un réacteur de CVD, ledit réacteur comprenant des moyens de commande de la température et de la pression dans ladite enceinte,
introduction d'un composé de dépôt composite et d'un composé oxydant dans une phase vapeur dans l'enceinte jouxtant le substrat,
le composé de dépôt composite étant choisi pour être une combinaison d'un premier composé de dépôt et d'un second composé de dépôt, ledit premier composé de dépôt étant un composé source de silicium ayant son silicium exempt de liaison directe avec de l'oxygène et étant contenu dans ledit composé composite dans approximativement 5 à 95 parties en poids et ledit second composé de dépôt étant un composé source de silicate avec au moins un oxygène lié directement à son silicium, et
dissociation thermique du composé de dépôt composite et du composé oxydant dans la phase vapeur et jouxtant le substrat à une température dépassant
approximativement 300°C, pour provoquer le dépôt et la formation du film de dioxyde de silicium sur ledit substrat.

2. Procédé selon la revendication 1 dans lequel la proportion du composé source de silicium par rapport au composé source de silicate dépend de la géométrie de marches du substrat pour réaliser un compromis entre la dureté ou la densité et la conformalité désirées ainsi que le taux d'attaque pour le film de dioxyde de silicium, la proportion étant faible pour obtenir une conformalité augmentée, et élevée pour obtenir une densité accrue.

3. Procédé selon la revendication 1 ou 2 comprenant en outre l'étape de maintien de pression dans l'enceinte à un niveau commandé pouvant atteindre 1,01325 10⁵ Pa (1 atm).

4. Procédé selon l'une quelconque des revendications 1 à 3 dans lequel un état de basse pression inférieur à 666 Pa (5 Torr) est maintenu dans l'enceinte.

5. Procédé selon l'une quelconque des revendications 1 à 4 dans lequel le composé source de silicium a la structure 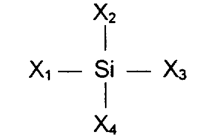 où X₁ - X₄ sont exempts d'oxygène au voisinage de leurs siliciums et le composé source de silicate a la structure 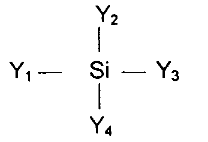 où au moins un des substituants Y₁ -Y₄ comprend un oxygène adjacent au silicium.

6. Procédé selon la revendication 5 dans lequel le composé source de silicium est choisi dans la classe constituée des silanes, des composés organosiliciés, des halogénures de silicium et des mélanges de ceux-ci.

7. Procédé selon la revendication 5 dans lequel le composé source de silicate est choisi dans une classe constituée des formes mono, di-, tri-, tétra- des silicates alcoxylés et des silicates cycliques alcoxylés, des dérivés halogénures de ceux-ci et des mélanges de ceux ci-dessus.

8. Procédé selon la revendication 5 dans lequel le composé source de silicate est choisi dans la classe constituée des formes mono, di-, tri-, tétra- des silicates alcoxy lés et de silicates cycliques, des dérivés halogénures de ceux-ci et de mélanges de ceux ci-dessus.

9. Procédé selon l'une quelconque des revendication 1 à 4, dans lequel le composé source de silicium est un silane et le composé source de silicate est du tétraalcyloxyorthosilicate ou du silicate tétraalcoxycyclique.

10. Procédé selon l'une quelconque des revendications 1 à 4 dans lequel le composé source de silicium est un tétraéthoxyorthosilicate ou un tétraéthylcycloxyorthosilicate

11. Dispositif au silicium ayant une surface avec des marches, un film de dioxyde de silicium disposé sur celle-ci dans un réacteur de CVD en utilisant l'un quelconque des procédés selon les revendications 1 à 10, dans lequel ledit film de dioxyde de silicium présente des caractéristiques de film d'environ 0,05 à 3 10⁸ Pa (0,05-3 x 10⁹ dynes/cm ) de contrainte, environ 1000-2000 angströms/mn de taux d'attaque, lorsqu'il est attaqué par de l'acide fluorhydrique standard à 10% dans l'eau, et une couverture de marches d'environ 80-95%.

12. Dispositif selon la revendication 11 dans lequel la contrainte est d'environ 0,05-0,5 x 10⁸ Pa.

13. Dispositif selon la revendication 11 dans lequel le taux d'attaque , lorsque l'attaque est faite avec de l'acide fluorhydrique standard à 10% dans l'eau, est d'environ 1000-1500 angströms/mn.

14. Dispositif selon la revendication 11 dans lequel la couverture de marches est d'environ 82-92 %.
